Europäisches Patentamt

European Patent Office

Office européen des brevets

(11) Numéro de publication: **0 346 211 B1**

(12) **FASCICULE DE BREVET EUROPEEN**

(45) Date de publication de fascicule du brevet: **29.12.93** (51) Int. Cl.5: **H03K 17/96**

(21) Numéro de dépôt: **89401558.5**

(22) Date de dépôt: **06.06.89**

(54) **Touche perfectionnée exploitant les propriétés d'un cristal liquide.**

(30) Priorité: **08.06.88 FR 8807625**

(43) Date de publication de la demande:
**13.12.89 Bulletin 89/50**

(45) Mention de la délivrance du brevet:
**29.12.93 Bulletin 93/52**

(84) Etats contractants désignés:
**DE ES GB IT**

(56) Documents cités:
EP-A- 0 079 711      EP-A- 0 086 135
FR-A- 2 295 644      GB-A- 2 138 571
US-A- 4 224 615      US-A- 4 405 918

ELECTRONIC LETTERS vol.8, no.25/26, décembre 1982, pages 1106-1108;
M.J.Bradshaw et al: "New forms of liquid
crystal touch switch"

REVIEW OF SCIENTIFIC INSTRUMENTS
vol.55, no.1, janvier 1984, pages 79-87;
F.I.Mopsik: "Precision time-domain dielectric
spectrometer"

(73) Titulaire: **JAEGER**
**2, rue Baudin**
**F-92303 Levallois-Perret(FR)**

(72) Inventeur: **Rydel, Charles**
**70, rue d'Aubervilliers**
**F-75019 Paris(FR)**

(74) Mandataire: **Warcoin, Jacques et al**
**Cabinet Régimbeau**
**26, avenue Kléber**
**F-75116 Paris (FR)**

EP 0 346 211 B1

## Description

La présente invention concerne le domaine des capteurs tactiles, c'est-à-dire des capteurs ou touches aptes à détecter une sollicitation digitale en vue de la commande d'un système annexe.

De nombreux types de capteurs tactiles ou touches ont déjà été proposés.

On a en particulier proposé, comme décrit dans les documents ELECTRONIC LETTERS, volume 18, no. 25/26, décembre 1982, pages 1106-1108 ; M.J. BRADSHAW et al : "New form of liquid crystal touch switch", EP-A-0 079 711, GB-A-2 138 571 et US-A-4 224 615, des touches comprenant une cellule à cristal liquide sujette à une variation de capacité lorsqu'elle reçoit un effort mécanique et placée dans un pont de détection, afin de déceler une telle variation de capacité. La cellule à cristal liquide permet également d'opérer simultanément un affichage normal.

Le document GB-A-2138571 décrit un capteur comprenant des cellules à cristaux liquides et des moyens de détection sensibles à une variation de la constante diélectrique du cristal liquide qui comprennent un générateur de signal électrique HF relié entre une électrode de base des cellules à cristaux liquides et une masse et un filtre relié à une électrode de commande desdites cellules à cristaux liquides.

Le document FR-A-2295644 décrit un dispositif de commutation qui comprend une électrode plane émettrice et une électrode plane réceptive coplanaire de l'électrode émettrice, un générateur de signaux relié à l'électrode émettrice, un organe de commutation relié à l'électrode réceptrice et un blindage isolé galvaniquement par rapport aux électrodes, qui entoure celles-ci. Les signaux sont transmis à l'électrode réceptrice lorsque rien ne touche le blindage. En revanche, le couplage entre l'électrode émettrice et l'électrode réceptrice est amorti si un organe électriquement conducteur touche le blindage.

Les dispositifs décrits dans les documents précités ne permettent cependant pas, tout du moins avec des moyens simples et économiques, d'utiliser simultanément les cellules à cristal liquide pour opérer un affichage normal.

La présente invention a maintenant pour but d'exploiter, sous forme de capteur tactile, la propriété spécifique des cristaux liquides, notamment des cristaux liquides nématiques en hélice, selon laquelle une sollicitation mécanique d'un cristal liquide nématique en hélice, à l'état excité, entraîne une modification temporaire de l'agencement des molécules qui s'accompagne d'une variation notable, mais fugitive, de la constante diélectrique, tout en autorisant simultanément l'exploitation de la cellule à cristal liquide en mode d'affichage classique.

Pour cela, la présente invention propose un capteur tactile comprenant :
- une cellule à cristal liquide comportant deux plaques de verre séparées par un cristal liquide munies respectivement sur leur face interne, d'une électrode de base et d'au moins une électrode de commande, et
- des moyens de détection sensibles à une variation de la constante diélectrique du cristal liquide qui comprennent un générateur de signal électrique HF relié entre l'électrode de base et une masse, et un filtre apte à intégrer les charges créées par la variation de constante diélectrique du cristal liquide, relié à chaque électrode de commande,
  caractérisé par le fait qu'il comprend :
- des moyens de commande conçus pour contrôler l'état visuel de la cellule à cristal liquide et qui comprennent des portes logiques en nombre égal au nombre d'électrodes de commande dont les sorties sont reliées respectivement à ces électrodes de commande, et un générateur qui produit un signal électrique basse fréquence dont la sortie est reliée à l'électrode de base et à une première entrée de chaque porte logique, tandis que la seconde entrée de ces portes reçoit un signal logique de commande fonction de l'état visuel recherché pour la cellule, et
- un circuit logique de sortie qui reçoit les signaux logiques de commande et opère une discrimination entre un signal impulsionnel en sortie du filtre qui provient d'une variation de constante diélectrique du cristal liquide liée a une sollicitation mécanique de la cellule et un signal impulsionnel en sortie du filtre qui provient d'une variation de la constante diélectrique du cristal liquide liée à un changement d'état d'un signal de commande.

D'autres caractéristiques, buts et avantages de la présente invention apparaîtront à la lecture de la description détaillée qui va suivre, et en regard des dessins annexés donnés à titre d'exemples non limitatifs et sur lesquels :

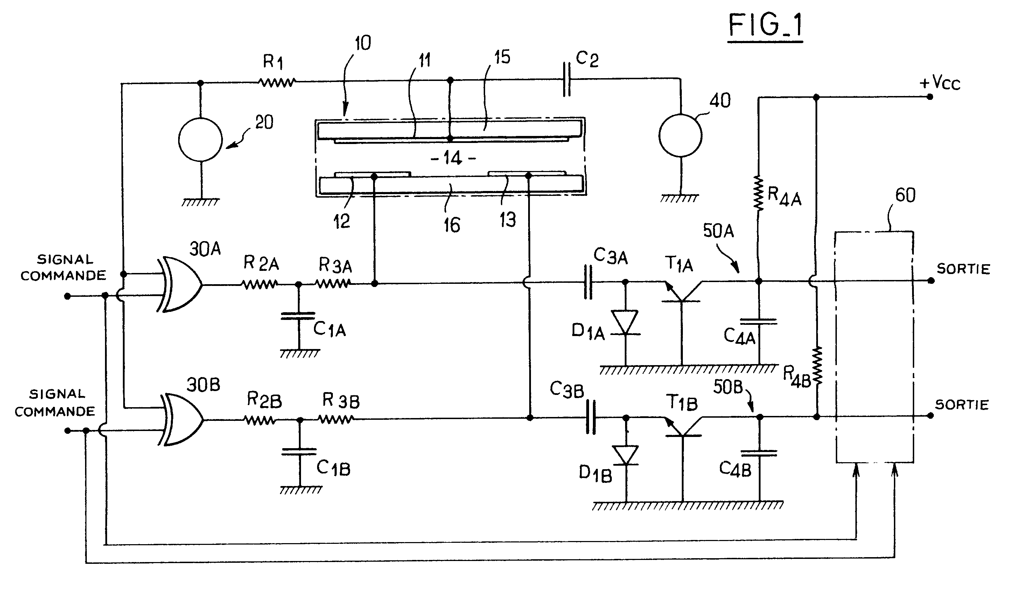

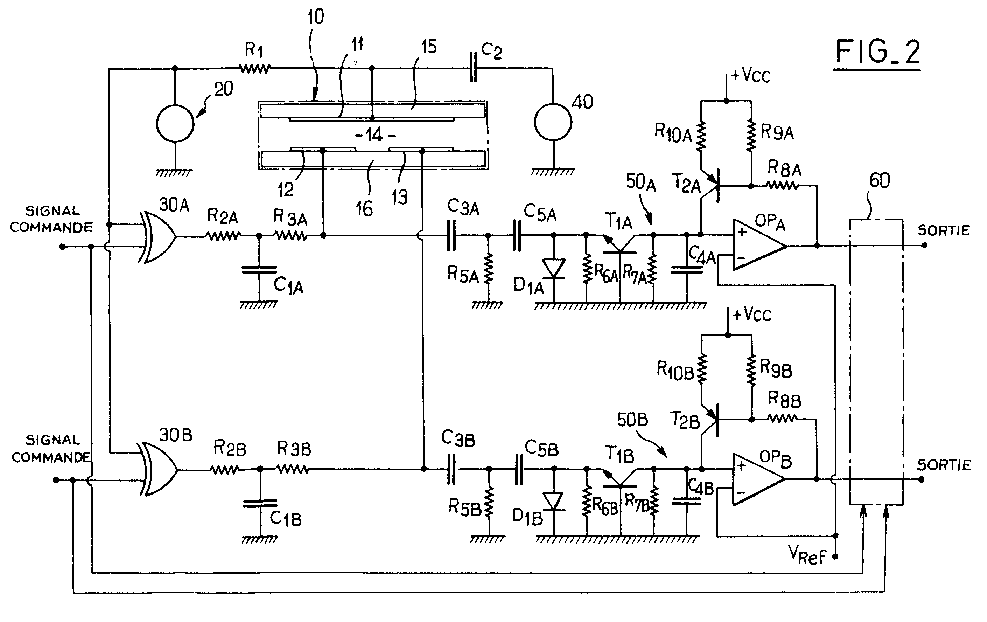

- les figures 1 et 2 représentent deux variantes de réalisation d'un dispositif conforme à la présente invention.

On va dans un premier temps décrire le mode de réalisation représenté sur la figure 1 annexée.

On a représenté schématiquement sur la figure 1, sous la référence 10, une cellule optique classique à cristal liquide.

La cellule 10 comprend de façon connue en soi deux plaques de verre 15, 16, distantes par exemple d'une dizaine de microns. La plaque de verre 15 est munie sur sa face interne d'une électrode de base 11. La seconde plaque de verre 16 est munie sur sa face interne d'électrodes de commande 12, 13. Sur la figure 1, on a illustré schématiquement deux électrodes de commande 12, 13, sur la face interne de la plaque de verre 16. La présente invention peut cependant trouver application dans des cellules optiques à cristaux liquides comprenant un nombre quelconque d'électrodes de commande sur la face interne de la plaque de verre 16. La présente invention peut trouver application dans une cellule optique 10 à cristal liquide comprenant une seule électrode de commande sur la face interne de la plaque de verre 16. Elle trouve également application dans les cellules optiques 10 à cristal liquide comprenant un nombre important d'électrodes de commande 12, 13, sur la face interne de la plaque 16, comme cela est généralement le cas dans les dispositifs d'affichage à cristal liquide.

Le cristal liquide 14 est placé entre les plaques de verre 15, 16. Il est formé de préférence d'un cristal liquide nématique.

Les molécules de ce cristal liquide sont parallèles aux plaques. Mais grâce à un traitement adéquat connu en soi des plaques 15, 16, on définit des directions d'ancrage généralement orthogonales entre elles. Ainsi, au repos les molécules du cristal liquide nématique se placent en hélice.

La structure en hélice des molécules peut être détruite simplement par application d'une tension de quelques volts entre l'électrode de base 10 et l'une des électrodes de commande 12 ou 13. Lors de l'application d'une telle tension de commande, les molécules du cristal liquide s'orientent perpendiculairement aux plaques.

On rappelle qu'une telle cellule optique à cristal liquide nématique en hélice est généralement placée entre deux polariseurs de lumière croisés. En l'absence de signal de commande entre l'électrode de base 11 et les électrodes de commande 12, 13, la structure en hélice des molécules du cristal liquide fait tourner de 90° le plan de polarisation de la lumière qui la traverse. La lumière peut donc traverser les deux polariseurs et la cellule à cristal liquide. Par contre, lorsque l'hélice est détruite par application d'un signal de commande les deux polariseurs croisés interdisent tout passage de lumière.

La cellule 10 utilisée dans le cadre de la présente invention peut être associée à de tels polariseurs croisés. Le capteur tactile conforme à la présente invention peut en effet de préférence être intégré à un écran d'affichage. Cependant, les polariseurs croisés précités n'ont pas été représentés sur les figures annexées afin de simplifier l'illustration.

Comme indiqué précédemment la Demanderesse propose d'exploiter la propriété constatée expérimentalement d'une telle cellule 10 à cristal liquide, selon laquelle une sollicitation mécanique perpendiculairement aux plaques 15, 16, lorsque la cellule 10 est excitée par un signal de commande, entraîne une modification temporaire de l'agencement des molécules qui s'accompagne d'une variation notable mais fugitive de la constante diélectrique.

Les moyens sensibles à la variation de la constante diélectrique du cristal liquide 14 comprennent pour l'essentiel un générateur de signal électrique HF 40 et des moyens 50 aptes à intégrer les charges créées par la variation de cette constante diélectrique.

Plus précisément encore dans le cadre de la présente invention, il est prévu un générateur HF 40 unique, mais autant d'étages intégrateurs que la cellule 10 comprend d'électrodes de commande 12, 13, utilisées pour détecter une sollicitation digitale.

Le générateur HF 40 a l'une de ses bornes reliée à la masse. La seconde borne du générateur 40 est reliée par l'intermédiaire d'une capacité de liaison C2 à l'électrode de base 11.

Les différents étages d'intégration sont de structure identique. Les éléments qui composent les deux étages d'intégration associés respectivement aux électrodes de commande 12, 13 selon l'illustration de la figure 1 portent des références numériques identiques assorties respectivement d'indice A et B.

Chacun des étages d'intégration comprend un filtre passe-bas 50A, 50B relié à une électrode de commande associée 12 ou 13 par l'intermédiaire d'un transistor T1A, T1B à base commune.

Selon le mode de réalisation illustré sur les figures annexées, les filtres passe-bas 50A, 50B, comprennent une résistance R4A, R4B, et un condensateur C4A, C4B, connectés en série entre une borne d'alimentation positive +Vcc et la masse du montage. La résistance R4A, R4B, est prévue côté borne d'alimentation positive +Vcc tandis que le condensateur C4A, C4B est prévu côté masse du montage.

Le transistor T1A, T1B, a sa base connectée à la masse du montage. Le collecteur du transistor T1A, T1B est relié au point milieu du filtre passe-bas 50A ou 50B.

L'émetteur du transistor T1A, T1B, est relié par l'intermédiaire d'un condensateur de liaison C3A, C3B, à une électrode de commande 12 ou 13 respectivement associée.

Enfin, une diode D1A, D1B, est reliée entre, d'une part, le point commun aux condensateurs de liaison C3A, C3B, et l'émetteur du transistor T1A, T1B associé et, d'autre part, la masse du montage. Plus précisément, l'anode de la diode D1A, D1B, est reliée à l'émetteur du transistor T1A ou T1B associé tandis que la cathode de cette diode est reliée à la masse du montage.

La capacité des condensateurs de liaison C3A et C3B doit être grande par rapport à la capacité du condensateur formé par le cristal liquide 14 associé aux électrodes 11, 12, 13, afin de transmettre les variations de charge créées par la variation de constante diélectrique du cristal liquide, tout en supprimant la composante continue.

La capacité des condensateurs de liaison C3A, C3B, est de préférence au moins égale à dix fois la capacité du condensateur formé par le cristal liquide 14.

A chaque alternance du signal issu du générateur HF 40, le condensateur se charge à travers la diode D1A, D1B, lorsque le potentiel en sortie du générateur 40 s'accroit. Puis le potentiel stocké aux bornes de ce condensateur provoque la conduction du transistor T1A, T1B, à chaque alternance, lorsque le potentiel en sortie du générateur décroit.

Chacun des étages d'intégration à base d'un filtre passe-bas 50A, 50B, transforme donc la variation de capacité du cristal liquide 14 en variation de courant dans la résistance R4A ou R4B. Cette variation de courant est déterminée par la relation :

C. [V - (Vbe + Vd)] F

dans laquelle :
- C représente la variation de capacité du cristal liquide 14,
- V représente la tension crête de charge du condensateur C4A ou C4B,
- Vbe représente la chute de tension entre la base et l'émetteur du transistor T1A, T1B à l'état conducteur,
- Vd représente la chute de tension aux bornes de la diode D1A, D1B à l'état passant, et
- F représente la fréquence du générateur HF 40.

A titre d'exemple non limitatif le générateur 40 peut générer un signal électrique d'amplitude V de 5 volts crête à crête et de fréquence F de l'ordre de 128 KHz.

Le cristal liquide 14 contenu entre l'électrode de base 11 et les électrodes de commande 12 et 13 est excité de façon connue en soi à l'aide d'un signal logique de commande avec superposition d'une composante alternative basse fréquence pour éviter l'électrolyse du cristal liquide 14. Là encore, il est prévu un générateur 20 unique générant la composante alternative basse fréquence précitée, mais autant d'étages de commande que d'électrodes de commande 12 ou 13 sur la plaque de verre 16. Les différents étages de commande sont de structure identique. Les éléments qui composent les deux étages de commande illustrés sur les figures annexées portent des références numériques identiques mais sont assortis respectivement d'indice A et B.

Le générateur 20 a une première borne reliée à la masse du montage. Sa seconde borne est reliée par l'intermédiaire d'une résistance de liaison R1 à l'électrode de base 11.

Chaque étage de commande comprend une porte logique OU exclusif 30A, 30B, et un filtre passe-bas.

La seconde borne du générateur 20 est reliée à une première entrée de chacune des portes logiques 30A, 30B. la seconde entrée des portes 30A, 30B, reçoit un signal de commande spécifique pour chacune des électrodes de commande 12, 13 associées.

La sortie des portes logiques 30A, 30B, est reliée à cette électrode 12 ou 13 par l'intermédiaire du filtre passe bas précité. Ce dernier comprend deux résistances R2A, R3A, ou R2B, R3B, et un condensateur C1A, C1B. Les deux résistances R2A, R3A ou R2B, R3B sont reliées en série entre la sortie de la porte logique 30B, 30B, et l'électrode de commande 12 ou 13 associée. Le condensateur C1A, C1B est relié entre le point commun des résistances R2A, R3A ou R2B, R3B et la masse du montage.

Le générateur 20 peut par exemple délivrer un signal carré O/5,6 volts à une fréquence de l'ordre de 60 Hz. Les filtres passe-bas prévus en sortie de portes logiques 30A et 30B permettent d'atténuer la transmission des fronts des signaux à 60 Hz issus du générateur 20. De préférence, les filtres passe-bas possèdent une constante de temps supérieure à une milliseconde.

De façon connue en soi, les molécules du cristal liquide 14 se placent en hélice lorsque le signal de commande appliqué sur la seconde entrée des portes logiques 30A, 30B est au niveau bas. Dans ce cas en effet, l'électrode de base 11 est au même potentiel que les électrodes de commande 12 ou 13. Par contre, l'agencement en hélice du cristal liquide est détruit lorsque le signal de commande précité est au niveau haut. Dans cet état excité une sollicitation mécanique de la cellule 10 perpendiculairement aux plaques de verre 15, 16, en regard de l'une des électrodes de commande 12, 13, entraîne une désorganisation temporaire des molécules du cristal liquide en regard de l'électrode de commande considérée et donc une variation fugitive localisée de la constante diélectrique. L'intégration des charges ainsi créées induit un signal impulsionnel à la sortie des filtres passe-bas 50A ou 50B.

En d'autres termes, selon la représentation de la figure 1, en supposant qu'un écart spatial suffisant existe entre les électrodes 12 et 13, une sollicitation mécanique de la cellule en regard de l'électrode 12 induit un signal impulsionnel à la sortie du filtre 50A, alors qu'une sollicitation mécanique de la cellule en regard de l'électrode 13 induit un signal impulsionnel à la sortie du filtre 50B.

On notera cependant que la modification de l'agencement des molécules de cristal liquide induite par application du signal de commande, provoque également une variation de constante diélectrique et donne lieu par conséquent à un signal en sortie des filtres passe-bas 50A, 50B.

De ce fait, il est souhaitable de prévoir en sortie du capteur un circuit logique schématiquement référencé sous la référence 60 qui assure une discrimination entre les signaux détectés en sortie des filtres 50A, 50B provenant d'une sollicitation mécanique de la cellule 10 et les signaux détectés en sortie des filtres 50A et 50B et résultant d'un changement d'état des signaux de commande d'entrée.

En d'autres termes, le signal logique de sortie 60 est conçu pour valider la sortie correspondante du capteur lors de l'apparition d'un signal impulsionnel en sortie d'un filtre 50A, 50B, en l'absence de changement d'état du signal de commande associé.

Le filtre passe-bas d'intégration des charges dûes à la variation de constante diélectrique du cristal liquide possède avantageusement une constante de temps de l'ordre de 10 millisecondes.

Le montage illustré sur la figure 1 permet de détecter efficacement la sollicitation mécanique de la cellule 10. On doit cependant noter que le point de fonctionnement du dispositif illustré sur la figure 1 varie en fonction de la capacité de la cellule à cristaux liquides 14.

Le montage illustré sur la figure 2 permet d'éliminer une telle variation de point de repos et par conséquent d'utiliser le même circuit électronique de détection avec différentes cellules 10 à cristal liquide.

On reconnaît sur la figure 2 la cellule 10, le générateur HF 40, le condensateur de liaison C2, le générateur BF 20, la résistance de liaison R1, les portes logiques 30A, 30B, les filtres passe-bas R2A, R3A, C1A, et R2B, R3B, C1B, les condensateurs de liaison C3A, C3B, les diodes D1A, D1B, les transistors T1A, T1B et le circuit logique de sortie 60. Ces éléments ne seront donc pas décrits plus en détail par la suite.

Le circuit de la figure 2 se distingue du circuit illustré sur la figure 1 essentiellement par l'utilisation d'une source de courant commandée placée en série respectivement de la résistance de chaque filtre passe-bas d'intégration.

Cette source de courant est formée d'un transistor PNP T2A, T2B, piloté par un signal proportionnel à l'écart entre un signal de référence et la sortie du filtre.

Le signal pilote est généré par un amplificateur opérationnel OPA, OPB. L'entrée non inverseuse de celui-ci est reliée à la sortie du filtre passe-bas assurant l'intégration, soit au collecteur du transistor T1A, T1B. L'entrée inverseuse de l'amplificateur opérationnel OPA, OPB, reçoit le signal de référence VRef. Le signal pilote est obtenu en sortie de l'amplificateur opérationnel OPA, OPB. La sortie de cet amplificateur opérationnel est reliée à la base du transistor T2A, T2B, par l'intermédiaire d'une résistance de liaison R8A, R8B. La base du transistor T2A, T2B est également reliée à une borne d'alimentation positive +Vcc par l'intermédiaire d'une résistance de polarisation R9A, R9B. L'émetteur du transistor T2A, T2B est relié à la même borne d'alimentation positive +Vcc par l'intermédiaire de la résistance R10A, R10B. Enfin, le collecteur du transistor T2A, T2B est relié au point commun au condensateur C4A, C4B et au collecteur du transistor T1A, T1B.

Pour l'essentiel, la source de courant commandée fonctionne comme suit : si la tension sur le collecteur des transistors T1A, T1B, tend à baisser, la tension de sortie du comparateur baisse et le courant généré par la source T2A, T2B augmente.

Le dispositif illustré sur la figure 2 annexée se distingue également de celui représenté sur la figure 1 par la présence de filtres passe-haut entre le condensateur de liaison C3A, C3B et le transistor T1A, T1B. Ces filtres passe-haut ont pour but d'améliorer l'élimination de la composante alternative basse fréquence de 60 Hz issue du générateur 20. Ces filtres passe-haut comprennent une résistance R5A, R5B et un condensateur C5A, C5B. Le condensateur C5A, C5B est connecté entre le condensateur de liaison C3A, C3B et l'émetteur du transistor T1A, T1B. La résistance R5A, R5B, est connectée entre le point commun aux condensateurs C3A, C5A, ou C3B, C5B et la masse du montage. Les filtres passe-haut précités peuvent présenter par exemple une constante de temps supérieure à une seconde.

Comme indiqué précédemment, la présente invention permet d'intégrer directement les capteurs tactiles dans un écran d'affichage à cristal liquide. Elle permet par conséquent de supprimer tout bouton mécanique et d'améliorer à la fois la fiabilité et l'ergonomie des systèmes. Ces caractéristiques s'avèrent particulièrement importantes dans le cadre de la réalisation d'équipements embarqués pour véhicule automobile.

On a évoqué ci-dessus l'utilisation de cristaux liquides nématiques. La présente invention peut cependant utiliser tout autre type de cristal liquide présentant une variation de constante diélectrique lors d'une sollicitation mécanique.

**Revendications**

1.  Capteur tactile comprenant :
    - une cellule à cristal liquide (10) comportant deux plaques de verre (15, 16) séparées par un cristal liquide (14) et munies respectivement sur leur face interne, d'une électrode de base (11) et d'au moins une électrode de commande (12, 13), et
    - des moyens de détection (40, 50A, 50B) sensibles à une variation de la constante diélectrique du cristal liquide qui comprennent un générateur de signal électrique HF (40) relié entre l'électrode de base et une masse, et un filtre (50A, 50B) apte à intégrer les charges créées par la variation de constante diélectrique du cristal liquide, relié à chaque électrode de commande,
    caractérisé par le fait qu'il comprend :
    - des moyens de commande (20, 30A, 30B) conçus pour contrôler l'état visuel de la cellule à cristal liquide (10) et qui comprennent des portes logiques (30A, 30B) en nombre égal au nombre d'électrodes de commande (12, 13) dont les sorties sont reliées respectivement à ces électrodes de commande, et un générateur (20) qui produit un signal électrique basse fréquence dont la sortie est reliée à l'électrode de base et à une première entrée de chaque porte logique (30A, 30B), tandis que la seconde entrée de ces portes reçoit un signal logique de commande fonction de l'état visuel recherché pour la cellule, et
    - un circuit logique de sortie (60) qui reçoit les signaux logiques de commande et opère une discrimination entre un signal impulsionnel en sortie du filtre qui provient d'une variation de constante diélectrique du cristal liquide liée à une sollicitation mécanique de la cellule (10) et un signal impulsionnel en sortie du filtre qui provient d'une variation de la constante diélectrique du cristal liquide liée à un changement d'état d'un signal de commande.

2.  Capteur selon la revendication 1, caractérisé par le fait que chaque filtre est un filtre passe-bas (R4A, C4A ; R4B, C4B).

3.  Capteur selon l'une des revendications 1 ou 2, caractérisé par le fait que les moyens de détection comprennent un transistor (T1A, T1B) à base commune connecté entre une électrode de commande (12, 13) de la cellule à cristal liquide (10) et le filtre (50A, 50B)

4.  Capteur selon la revendication 3, caractérisé par le fait qu'une diode (D1A, D1B) est connectée en amont du transistor (T1A, T1B).

5.  Capteur selon l'une des revendications 1 à 4, caractérisé par le fait qu'il comprend un filtre passe-haut (R5A, C5A, R5B, C5B) en amont de chaque filtre (50A, 50B)

6.  Capteur selon l'une des revendications 1 à 5, caractérisé par le fait qu'il comprend une source de courant commandée (T2A, T2B) en sortie de chaque filtre (50A, 50B).

7.  Capteur selon la revendication 6, caractérisé par le fait que la source de courant commandée (T2A, T2B) est pilotée par un signal proportionnel à l'écart entre un signal de référence (VRef) et la sortie du filtre.

8.  Capteur selon l'une des revendication 1 à 7, caractérisé par le fait que les portes logiques des moyens de commande sont du type OU exclusif (30A, 30B) et leur sortie est reliée par un filtre passe-bas aux électrodes de commande (12, 13) de la cellule (10).

9.  Capteur selon l'une des revendications 1 à 8, caractérisé par le fait que le cristal liquide (14) est un cristal liquide nématique.

**Claims**

1.  A touch sensor comprising :
    - a liquid crystal cell (10) including two glass plates (15, 16) separated by a liquid crystal (14), provided respectively on their inside face with a base electrode (11) ant at least a control electrode (12, 13), and
    - detector means (40, 50A, 50B) responsive to a change in the dielectric constant of the liquid crystal which comprises an HF electrical signal generator (40) connected between the base electrode and a ground, and a filter (50A, 50B) suitable to integrate the charges created by any change in the dielectric constant of the liquid crystal, connected to each control electrode,
    characterized in that it comprises :
    - control means (20, 30A, 30B) adapted to control the optical state of the liquid crystal cell (10) and which includes logical gates (30A, 30B) in a number equal to the control electrodes (12, 13), said gates having their outputs respectively connected to these control electrodes, and a generator (20) which produces a low frequency electrical signal and which has its output connected to the base electrode and to a first input of each logical gate (30A, 30B), while the second input of theses gates receive a control logical signal which depends from the optical stated required for the cell, and

- an output logical circuit (60) which receives the control logical signals and operates a discrimination between a pulse output signal of the filter due to a change in the dielectric constant of liquid crystal related to mechanical force applied to the cell (10) and a pulse signal at the output of the filter due to a change in the dielectric constant of liquid crystal related to a change in the state of a control signal.

2. A sensor according to the claim 1, characterized by the fact that each filter is a low-pass filters (R4A, C4A ; R4B, C4B).

3. A sensor according to any one of the claims 1 or 2, characterized by the fact that the detection means include a common-base transistor (T1A, T1B) connected between a control electrodes (12, 13) of the liquid crystal cell (10) and the filter (50A, 50B).

4. A sensor according to claim 3, characterized by the fact that a diode (D1A, D1B) is connected upstream from each transistor (T1A, T1B).

5. A sensor according to any one of claims 1 to 4, characterized by the fact that it includes a highpass filters (R5A, C5A ; R5B, C5B) upstream from each filter (50A, 50B).

6. A sensor according to any one of claims 1 to 5, characterized by the fact that it includes a controlled current source (T2A, T2B) at the output of each filter (50A, 50B).

7. A sensor according to claim 6, characterized by the fact that each controlled current source (T2A, T2B) is controlled by a signal proportional to the difference between a reference signal (VRef) ant the output of the filter.

8. A sensor according to any one of claims 1 to 7, characterized by the fact that the logical gates of the control means are of the type exclusive-OR logic gates (30A, 30B) which have respective outputs connected via lowpass filters to the control electrodes (12, 13) of the cell (10).

9. A sensor according to any one of claims 1 to 8, characterized by the fact that the liquid crystal (14) is a nematic liquid crystal.

**Patentansprüche**

1. Berührungsschalter mit
   - einer Flüssigkristallzelle (10) mit zwei Glasplatten (151 16), welche durch einen Flüssigkristall (14) getrennt sind und an ihrer inneren Oberfläche mit einer Basiselektrode (11) bzw. mindestens einer Steuerelektrode (12, 13) versehen sind, und
   - eine Detektiereinrichtung (40, 50A, 50B), die auf eine Änderung der dielektrischen Konstante des Flüssigkristalls anspricht und die einen Generator für ein elektrisches Hochfrequenzsignal (40), welcher zwischen der Basiselektrode und der Masse geschaltet ist, und einen Filter (50A, 50B) umfaßt, welcher dafür geeignet ist, die durch die Änderung der dielektrischen Konstante des Flüssigkristalls erzeugte Ladung zu integrieren, und mit jeder Steuerelektrode verbunden ist,
   dadurch **gekennzeichnet,** daß er umfaßt:
   - eine Steuereinrichtung (20, 30A, 30B), welche dafür vorgesehen ist, den visuellen Zustand der Flüssigkristallzelle (10) zu regeln und welche logische Gatter (30A, 30B) in der gleichen Anzahl wie der der Steuerelektroden (12, 13), deren Ausgänge jeweils mit diesen Steuerelektroden verbunden sind, und einen Generator (20) umfaßt, welcher ein elektrisches Tieffrequenzsignal erzeugt und dessen Ausgang mit der Basiselektrode und einem ersten Eingang jedes logischen Gatters (30A, 30B) verbunden ist, während der zweite Eingang dieser Gatter ein logisches Steuersignal in Abhängigkeit von dem visuellen Zustand empfängt, der für die Zelle gewünscht ist, und
   - einen logischen Ausgangsschaltkreis (60), welcher die Steuersignale empfängt und eine Unterscheidung zwischen einem Impulssignal am Ausgang des Filters, welches auf eine Änderung der dielektrischen Konstante des Flüssigkristalls zurückzuführen ist, die mit einer mechanischen Beanspruchung der Zelle (10) zusammenhängt, und einem Impulssignal am Ausgang des Filters, welches auf eine Änderung der dielektrischen Konstante des Flüssigkristalls zurückzuführen ist, welche mit einer Änderung des Zustands eines Steuersignals zusammenhängt, bewirkt.

2. Schalter nach Anspruch 1, dadurch **gekennzeichnet**, daß jeder Filter ein Tiefpaßfilter (R4A, C4A; R4B, C4B) ist.

3. Schalter nach einem der Ansprüche 1 oder 2, dadurch **gekennzeichnet,** daß die Detektionseinrichtung einen Transistor mit gemeinsamer Basis (T1A, T1B) umfaßt, welcher zwischen eine Steuerelektrode (12, 13) der Flüssigkristallzelle (10) und den Filter (50A, 50B) geschaltet ist.

4. Schalter nach Anspruch 3, dadurch **gekennzeichnet,** daß eine Diode (D1A, D1B) in Flußrichtung vor dem Transistor (T1A, T1B) geschaltet ist.

5. Schalter nach einem der Ansprüche 1 bis 4, dadurch **gekennzeichnet**, daß er einen Hochpaßfilter (R5A, C5A, R5B, C5B) in Flußrichtung vor jedem Filter (50A, 50B) umfaßt.

6. Schalter nach einem der Ansprüche 1 bis 5, dadurch **gekennzeichnet**, daß er eine gesteuerte Stromquelle (T2A, T2B) am Ausgang jedes Filters (50A, 50B) umfaßt.

7. Schalter nach Anspruch 6, dadurch **gekennzeichnet,** daß die gesteuerte Stromquelle (T2A, T2B) durch ein Signal geführt wird, das proportional zu der Abweichung zwischen einem Referenzsignal ($V_{Ref}$) und dem Ausgang des Filters ist.

8. Schalter nach einem der Ansprüche 1 bis 7, dadurch **gekennzeichnet**, daß die logischen Gatter der Steuereinrichtung ausschließliche ODER-Gatter (30A, 30B) sind und ihr Ausgang über einen Tiefpaßfilter mit den Steuerelektroden (12, 13) der Zelle (10) verbunden sind.

9. Schalter nach einem der Ansprüche 1 bis 8, dadurch **gekennzeichnet**, daß der Flüssigkristall (14) ein nematischer Flüssigkristall ist.

FIG_1

SIGNAL COMMANDE

SIGNAL COMMANDE

SORTIE

SORTIE

+Vcc

EP 0 346 211 B1

FIG_2

EP 0 346 211 B1